Europäisches Patentamt

European Patent Office

Office européen des brevets

(11) Veröffentlichungsnummer: **0 448 763 A1**

# (12) EUROPÄISCHE PATENTANMELDUNG

(21) Anmeldenummer: 90106139.0

(22) Anmeldetag: 30.03.90

(51) Int. Cl.5: **H01L 21/285**, H01L 21/90

(43) Veröffentlichungstag der Anmeldung:
02.10.91 Patentblatt 91/40

(84) Benannte Vertragsstaaten:
**AT BE CH DE DK ES FR GB GR IT LI LU NL SE**

(71) Anmelder: **Siemens Aktiengesellschaft**
**Wittelsbacherplatz 2**
**W-8000 München 2(DE)**

(72) Erfinder: **Körner, Heinrich, Dr.-Dipl.-Chem.**
**Föhrenstrasse 17b**
**W-8206 Bruckmühl(DE)**
Erfinder: **Treichel, Helmuth, Dipl.-Ing. (FH)**
**Weldishoferstrasse 4**
**W-8900 Augsburg(DE)**
Erfinder: **Kücher, Peter, Dr.-Dipl.-Phys.**
**Gustav-Heinemann-Ring 34**
**W-8000 München 83(DE)**
Erfinder: **Hieber, Konrad, Dr.-Dipl.-Phys.**
**Am Herrenholz 10**
**W-8011 Grasbrunn(DE)**

(54) Verfahren und Vorrichtung zur Herstellung von leitenden Schichten oder Strukturen für höchstintegrierte Schaltungen.

(57) Bei einem Verfahren zur Herstellung von leitenden Schichten oder Strukturen für höchstintegrierte Schaltungen werden mindestens zwei Verfahrensstufen direkt hintereinander in verschiedenen Kammern (1 bis 6) einer Hochvakuum-Anlage ausgeführt, ohne die Hochvakuum-Bedingungen für das Halbleitersubstrat zu unterbrechen. Die Vermeidung einer Exposition an Luft zwischen den Verfahrensstufen liefert deutlich bessere Schichteigenschaften und ermöglicht insbesondere einfache und zuverlässige mehrstufige Verfahren zur Herstellung von leitenden Schichten, die eine Mehrlagenverdrahtung auf dem Halbleitersubstrat unterstützen. Eine verwendete Vorrichtung besteht aus mehreren Hochvakuum-Prozeßkammern (1 bis 6), mindestens einer die Prozeßkammern verbindenden Hochvakuum-Verteilerkammer (7) und mindestens zwei Hochvakuum-Vorratskammern (8, 9) für Halbleitersubstrate.

EP 0 448 763 A1

Die Erfindung betrifft ein mehrstufiges Verfahren zur Herstellung von leitenden Schichten oder Strukturen für höchstintegrierte Schaltungen auf einem Halbleitersubstrat sowie eine Vorrichtung zur Durchführung des Verfahrens.

Um bei der Herstellung von integrierten Schaltungen in der Mikroelektronik eine möglichst große Integrationsdichte zu erreichen, ist es bekannt, die leitenden Verbindungen zwischen den einzelnen elektrischen Elementen der integrierten Schaltung in übereinander liegenden Ebenen anzuordnen (sog. Mehrlagenverdrahtung) und gleichzeitig die lateralen Abmessungen von Strukturen innerhalb einer Ebene zu verkleinern. Die technische Realisierung dieser Aufgabe erfordert eine weitgehende Einebnung der vertikalen Schichtabfolge, wie in dem Artikel von A. Saxena und D. Pramanik in Solid State Technology, Okt. 1986, S. 95 - 100 eingehend erläutert wird. In diesem Artikel sind auch einige dem Stand der Technik entsprechende Verfahren beschrieben, mit welchen leitende und nicht leitende Schichten und Strukturen auf einem Halbleitersubstrat, üblicherweise einem Silizium-Substrat, hergestellt werden können, die die Halbleiteroberfläche zumindest teilweise planarisieren und damit die Mehrlagenverdrahtung unterstützen.

Allen bekannten Methoden ist gemeinsam, daß mehrere verschiedene Verfahren nacheinander ausgeführt werden müssen, um leitende Verbindungen herzustellen, die die Mehrlagenverdrahtung unterstützen. Dies wird im folgenden an einem Beispiel erläutert:

Zur Herstellung von Leitbahnen werden üblicherweise Schichten aus Aluminium oder einer Aluminium-Legierung durch ein Aufstäubverfahren auf die Oberfläche des Halbleitersubstrats aufgebracht. Solchermaßen hergestellte Schichten weisen eine schlechte Kantenbedeckung bei engen Strukturen, beispielsweise Kontaktlöchern, auf, wodurch die auf der Halbleiteroberfläche vorkommenden Höhenunterschiede nicht eingeebnet, sondern sogar noch vergrößert werden. Daher muß entweder die aufgestäubte Aluminium-Schicht einer Nachbehandlung unterzogen werden, beispielsweise einem Verfließen durch kurzzeitiges Erhitzen, oder es muß mit einer anschließend aufgebrachten nicht-leitenden Schicht der Höhenunterschied ausgeglichen werden. Im ersten Fall führt die nach dem Stand der Technik notwendige Exposition der Aluminium-Schicht an Luft zu einer Aluminium-Oxid enthaltenden passivierenden Schicht, die den Verfließprozeß erschwert, im zweiten Fall müssen mehrere aufwendige Verfahren für die Herstellung einer planarisierenden isolierenden Schicht eingesetzt werden (z. B. Abscheiden von Siliziumoxid -Aufschleudern einer Hilfsschicht und Ausheizen -Rückätzung der Hilfsschicht und der Siliziumoxidschicht -erneutes Abscheiden von Siliziumoxid).

Diese zweite Variante hat ferner den Nachteil, daß die Leitbahnen der nächstfolgenden leitenden Schicht nicht beliebig angeordnet werden können; insbesondere die jeweils zwei Leitbahnebenen verbindenden Kontaktlöcher nicht übereinander gestapelt werden können.

Sowohl aus Gründen der elektrischen Zuverlässigkeit der Leitbahnen als auch zur Unterstützung der Mehrlagenverdrahtung wird daher eine bessere Kantenbedeckung der abgeschiedenen leitenden Schichten angestrebt. Dazu ist es bekannt, Aluminium-Schichten mit Hilfe einer chemischen Abscheidung aus der Gasphase (sog. CVD-Prozeß) herzustellen.

Dabei kann als Ausgangssubstanz Triisobutyl-Aluminium (TIBA) verwendet werden, jedoch ist das Verfahren mit erheblichen Nachteilen verbunden (siehe D. Beach, S. Blum, F. LeGoues in Journal of Vacuum Science and Technology, A7 (5), 1989, S. 3117-18): Gefährlichkeit der Ausgangsverbindung bei gleichzeitig geringem Umsatzgrad; Instabilität von TIBA bei Temperaturen oberhalb von $50°$ C; einfache Herstellung einer Aluminiumlegierung unmöglich; geringe Abscheiderate, die den Einsatz einer Mehrscheibenanlage (Batch-System) erfordert; Notwendigkeit einer Bekeimung der zu beschichtenden Oberfläche, deren Gleichmäßigkeit auf strukturierten Oberflächen kaum zu gewährleisten ist. Insgesamt handelt es sich um einen technisch sehr schwierigen Prozeß, der zu dem Aluminium-Schichten mit hoher Defektdichte und mangelhafter Elektromigrationsresistenz liefert. Deshalb wird in dem oben angegebenen Artikel die Verwendung von Trimethylaminaluminium als Ausgangssubstanz in einem CVD-Prozeß vorgeschlagen. Um zusammenhängende Aluminium-Schichten damit zu erzeugen, ist aber ebenfalls eine vorausgehende Bekeimung mit Titanchlorid notwendig, und eine Gleichmäßigkeit der Aluminium-Schicht ist erst ab einer Dicke von 200 nm gewährleistet.

Der Erfindung liegt daher die Aufgabe zugrunde, ein Verfahren zur Herstellung von leitenden Schichten und Strukturen für höchstintegrierte Schaltungen anzugeben, welches die geschilderten Nachteile der bekannten Verfahren nicht aufweist. Die damit hergestellten Schichten und Strukturen sollen die für höchstintegrierte Schaltungen erforderlichen elektrischen und mechanischen Eigenschaften besitzen und einen geringen Übergangswiderstand zu unterliegenden leitenden Schichten sowie eine gute Kantenbedeckung aufweisen. Insbesondere sollen sie die Mehrlagenverdrahtung unterstützen, d. h. weitere aufwendige Verfahren zur Planarisierung der Halbleiteroberfläche erübrigen. Ferner soll eine Vorrichtung angegeben werden, mit der ein solches Verfahren durchgeführt werden kann.

Diese Aufgabe wird durch ein Verfahren gemäß Patentanspruch 1 und einer Vorrichtung gemäß Patentanspruch 9 gelöst. Weiterbildungen der Erfindung sind Gegenstand von Unteransprüchen.

Durch das erfindungsgemäße mehrstufige Verfahren, bei dem unter Aufrechterhaltung der Hochvakuum-Bedingungen mehrere metallisierungsrelevante Verfahrensstufen direkt nacheinander durchgeführt werden, können leitende Schichten und Strukturen hergestellt werden, die deutlich bessere elektrische und mechanische Eigenschaften besitzen und darüber hinaus die Mehrlagenverdrahtung besonders gut unterstützen. Durch das permanente Verweilen des Halbleitersubstrats im Hochvakuum und den damit verbundenen weitestgehenden Ausschluß von Umgebungseinflüssen wie Sauerstoff- oder Wasserdampf-Spuren auch zwischen den Verfahrensstufen wird unter anderem:

- die Reoxidation frisch gereinigter Oberflächen verhindert, wodurch reproduzierbar niedrige Übergangswiderstände erzielt werden und Bekeimungsprobleme vermieden werden,
- die Defektdichte in den abgeschiedenen Schichten verringert
- die Haftung der einzelnen Schichten verbessert und deren mechanische Spannungen (Streß) vermindert,
- durch die Verhinderung eines natürlichen Oxids ermöglicht, daß auf einer abgeschiedenen Aluminium-Schicht sofort nachfolgend ein Legierungsbestandteil aufgebracht werden und eindiffundieren kann,
- durch die unterdrückte Bildung natürlicher Oxidhäute auf den Schichten die jeweilige Bekeimung wesentlich erleichtert.

Diese verbesserten Schichteigenschaften führen wiederum dazu, daß weitere Verfahren integriert werden können, d. h. direkt vorausgehend oder anschließend ebenfalls in derselben Hochvakuum-Anlage ohne Unterbrechung der Hochvakuumbedingungen für das Halbleitersubstrat durchgeführt werden können. Dadurch werden benötigte Prozeßzeiten, die Gefahr der Kontamination der zu bearbeitenden Halbleitersubstrate und andere Fehler durch äußere Einflüsse minimiert.

Die Erfindung wird im folgenden anhand von Ausführungsbeispielen näher dargestellt.

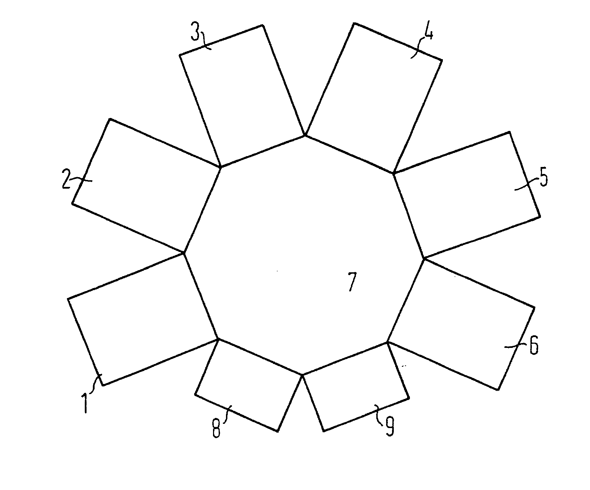

FIG 1    zeigt ein Ausführungsbeispiel der erfindungsgemäßen Vorrichtung in schematischer Darstellung.

Die Durchführung des erfindungsgemäßen mehrstufigen Verfahrens erfolgt in einer ein FIG 1 dargestellten Hochvakuum-Anlage, die aus mindestens zwei Hochvakuum-Prozeßkammern 1 - 6, mindestens einer Hochvakuum-Verteilerkammer 7 und mindestens zwei Hochvakuum-Vorratskammern 8, 9 besteht. Alle Vorrats- und Prozeßkammern haben eine hochvakuumtaugliche Verbindung zur Verteilerkammer 7, die in diesem Ausführungsbeispiel zentral angeordnet ist, und sind untereinander hochvakuummäßig isoliert und unabhängig. In den einzelnen Kammern sind bei den im folgenden angegebenen maximalen Leckraten (Einheit: mbar x 1 x $sec^{-1}$) die als zweite Größe angegebenen Basisdrücke (Einheit: mbar) mindestens erreichbar: Vorratskammern ($5 \times 10^{-6}/ 1 \times 10^{-6}$); Verteilerkammer ($5 \times 10^{-7}/ 1 \times 10^{-7}$); Prozeßkammern ($5 \times 10^{-7}/ 1 \times 10^{-7}$). Die einzelnen Prozeßkammern 1 - 6 sind spezifisch für einzelne Prozesse ausgelegt und können volumenmäßig klein sein. Die zu bearbeitenden, mit teilweise fertiggestellten integrierten Schaltungen versehen, im allgemeinen scheibenförmigen Siliziumsubstrate durchlaufen einzeln, nacheinander und zügig die verschiedenen Prozeßkammern 1 - 6 oder verweilen zur Abstimmung der Durchlaufzeiten oder Prozeßparameter in einem Zwischenlager der Verteilerkammer 7. Ablauf und Abfolge der Einzelprozeßschritte in den verschiedenen Prozeßkammern werden durch einen (nicht dargestellten) Prozeßrechner gesteuert.

Die einzelnen Prozeßkammern 1 bis 6 können beispielsweise folgendermaßen ausgestaltet sein: 1: Plasmaätzkammer, 2: Kammer zum Aufstäuben einer metallischen Kontaktierungsschicht, 3: Kammer für CVD-Prozesse, beispielsweise für Abscheidung einer als Barriere wirkende Schicht, 4: Kammer für CVD-Abscheidung einer als Leitbahn wirkenden Schicht, 5: Kammer zum Aufstäuben einer Deckschicht, 6: Kammer für einen Temperatur-Schritt (RTP) eventuell mit optischer Unterstützung (ROA). Dabei sind die Kammern mit den für die jeweiligen Prozesse bekanntermaßen notwendigen Einrichtungen ausgestattet, wie beispielsweise Gaszuleitungen, Elektroden für Plasmaätzverfahren oder plasmaunterstützte Abscheideverfahren, Metalltargets, Heizvorrichtungen und anderes.

Die erfindungsgemäße Vorrichtung eignet sich auch für mehrstufige Verfahren zur Herstellung von nicht-leitenden Schichten, bspw. von planarisierenden Isolationsschichten zwischen den Leitbahnebenen. Die Prozeßkammern 1 - 6 sind dann entsprechend den Erfordernissen auszubilden (z. B. für plasmaunterstützte CVD-Prozesse, Sputterätzverfahren, Plasmaätzverfahren, Temperaturbehandlungen).Ein wesentlicher Vorteil besteht dann in der Vermeidung einer Feuchtigkeitsaufnahme der isolierenden Schichten zwischen den Verfahrensstufen, wodurch sich bspw. ein sonst notwendiges Ausheizen der Schichten erübrigt.

Kleine Transferzeiten zwischen zwei Prozeßkammern über die zentrale Verteilerkammer 7 von etwa 20 sec ermöglichen hohe Durchlaufzahlen ohne menschliche Einflüsse oder Fehler. Während die Siliziumsubstrate aus einer Vorratskammer 8 bearbeitet werden, kann die andere Vorratskammer 9 von außen mit neuen Siliziumsubstraten beladen werden. Dadurch und durch den Einsatz einer Mehrkammeranlage mit zentraler Verteilerkammer ist ein permanentes kontinuierliches Prozessieren bei sequentieller Abfolge verschiedener Verfahren möglich. Wichtige damit verbundene ökonomische und Fertigungsaspekte sind die Reduktion der Anlagenvielfalt, Einsparung bei der beanspruchten Fläche in einem Reinraum und die Sicherstellung von geringen Durchlaufzeiten.

Anwendungsbeispiele für das erfindungsgemäße Verfahren:

1. Herstellung von Aluminium-Leitbahnen

Dieses mehrstufige Verfahren besteht vorteilhafterweise aus den folgenden Verfahrensstufen a1-a6:

(a₁)  Reinigung der zu beschichtenden Oberfläche
Das natürliche Oxid der freiliegenden Siliziumoberflächen wird durch einen plasmaunterstützten Ätzprozeß in der ersten Prozeßkammer nach bekannten Verfahren, beispielsweise mit $CF_4$ als Ätzgas, entfernt.

(a₂)  Aufbringen einer Kontaktschicht
Zur Verbesserung des elektrischen Kontakts zu den unterliegenden Silizium-Gebieten wird beispielsweise eine Titan-Schicht von etwa 10 bis 100 nm Dicke als Kontaktschicht aufgebracht. Dies kann mittels bekannter Aufstäubverfahren oder CVD-Verfahren durchgeführt werden, die Prozeßkammer 2 ist je nach gewünschtem Herstellverfahren entsprechend aufgebaut. Bei Einsatz eines CVD-Verfahrens wird eine geeignete titanhaltige Ausgangsverbindung mittels Trägergas oder durch Einsaugen in die Prozeßkammer 2 eingebracht und bei einem Prozeßdruck von 0,1 bis 100 mbar und einer Temperatur von etwa 200 bis 450° C thermisch angeregt. Zusätzlich kann eine Anregung durch ein Plasma erfolgen.

(a₃)  Aufbringen einer Barriereschicht
Um die Interdiffusion von Aluminium und Silizium zu verhindern, wird vorteilhafterweise eine als Barriere wirkende Titannitrid-Schicht in einer weiteren Prozeßkammer 3 aufgebracht. Die unterliegende Titan-Schicht dient gleichzeitig als Haftschicht für die aus Titannitrid bestehende Barriereschicht. Erfindungsgemäß wird zur Herstellung der Titannitrid-Schicht ein CVD-Prozeß eingesetzt, der als Ausgangssubstanz eine stickstoffhaltige organische Titan-Verbindung verwendet, welche thermisch, optisch und oder durch ein Plasma angeregt wird, und bei rein thermischer Anregung die Zugabe eines Reduktionsmittels vorsieht. Dieses Verfahren liefert bereits bei Prozeßtemperaturen im Bereich von 200 bis 550° C Titannitrid-Schichten mit besonders vorteilhaften Eigenschaften wie Konformität, Streßarmut, sehr gute Kantenbedeckung, hohe Barrierewirkung, gute Leitfähigkeit und andere.

(a₄)  Aufbringen einer CVD-Aluminiumschicht
Das Aufbringen der Aluminiumschicht mittels CVD erfolgt im Temperaturbereich von 200 bis 450° C bei einem Druck von 0,1 bis 100 mbar. Als Ausgangssubstanz wird eine organische Aluminiumverbindung eingesetzt, beispielsweise Dimethylaluminiumhydrid $HAl(CH_3)_2$, Trimethylaminaluminiumhydrid $AlH_3{*}N(CH_3)_3$ oder Triäthylaluminium $Al(Et)_3$, oder ähnliches. Diese Verbindungen besitzen Verdampfertemperaturen im Bereich von 5 bis 100° C, und werden mittels eines Trägergases oder durch Einsaugen in die Prozeßkammer 4 eingebracht. Die Eigenschaften des Aluminiums wie Korngröße oder Oberflächenrauhigkeit können sowohl durch geeignete Wahl der Ausgangskomponenten als auch durch Variation der Prozeßprarameter beeinflußt werden.

(a₅)  Aufbringen einer Legierungsbestandteile liefernden Schicht Zur Bildung einer Aluminium-Legierung wird eine kupfer-, titan-, palladium- oder siliziumhaltige Schicht aufgestäubt oder mittels CVD abgeschieden. Ihre Dicke wird von dem gewünschten Legierungsverhältnis bestimmt. Das Aufbringen der Schicht kann auch vor dem Aufbringen der Aluminiumschicht erfolgen.

(a₆)  Legieren der Aluminiumschicht
Durch einen Temperaturschritt, beispielsweise durch Rapid Thermal Processing (RTP) wird die gewünschte Aluminiumlegierung gebildet. Die Diffusion des Legierungsbestandteiles erfolgt hierbei vorzugsweise bei Temperaturen unterhalb von 500° C durch kurzzeitiges Erhitzen der Halbleitersubstrate (10 bis 80 sec) in einer Inertgas-Atmosphäre wie Helium oder Wasserstoff. Der Temperaturschritt kann auch mit optischer Unterstützung (Rapid Optical Annealing, ROA) bei Temperaturen bis zu 450° C für 10 bis 120 sec erfolgen.

Dieses Ausführungsbeispiel des erfindungsgemäßen Verfahrens ermöglicht es, Schichten selbst in engsten Strukturen konform und mit sehr guter Kantenbedeckung abzuscheiden. Dies wird ermöglicht durch die Wahl geeigneter CVD- oder Aufstäubverfahren und durch Abscheideparameter im Bereich der oberflächenkontrollierten Reaktionskinetik, sowie der Tatsache, daß die bei den CVD-Verfahren abzuscheidenden Schichtbestandteile bereits in einem einzigen Ausgangsmolekül vorhanden sind. Dadurch eignet sich ein solches Metallisierungsverfahren insbesondere für die Mehrlagenverdrahtung.

Der Einsatz eines CVD-Verfahrens für die Abscheidung der Titannitrid-Barriereschicht aus stickstoffhaltigen organischen Titan-Verbindungen liefert eine besonders gute Barriereschicht, so daß die sonst notwendige Absättigung der Korngrenzen mit Sauerstoff entfallen kann und die Integration mit der nachfolgenden Aluminium-Abscheidung ermöglicht wird. Das Herstellverfahren für die Aluminiumschicht verwendet keine gefährlichen oder hochreaktiven Ausgangssubstanzen. Der besondere Vorteil liegt in der Kombination der Titannitrid-Abscheidung mit sofort anschließender Aluminium-Abscheidung ohne Unterbrechung des Hochvakuums, da dadurch wider Erwarten eine Bekeimungsschicht für die Aluminiumabscheidung nicht notwendig ist. Auf der nicht oxidierten Titannitrid-Oberfläche wird Aluminium sehr gleichmäßig und unabhängig vom darunterliegenden Material abgeschieden. Dadurch ergeben sich eine kleinere durchschnittliche Aluminiumkorngröße, glattere Schichten und eine geringere Defektdichte der Aluminiumschicht verglichen mit bisher bekannten Aluminiumabscheideprozessen. Auch die Elektromigrationsresistenz und die Zuverlässigkeit der Metallisierung ist wesentlich besser und läßt sich noch weiter erhöhen beispielsweise durch Aufbringen einer Titannitrid-Deckschicht auf oder von entsprechenden Zwischenschichten innerhalb der Aluminiumschicht. Auch Kupfer oder Titan als unterliegende, Zwischen- oder Deckschicht bewirken eine weitere Verbesserung der elektrischen Eigenschaften der Metallisierung, insbesondere in Verbindung mit Temperaturschritten. Die Herstellung von Aluminiumlegierungs-Schichten kann auch in situ durch Zersetzung geeigneter Ausgangsverbindungen (bspw. AlH$_3$ *N(CH$_3$)$_3$ + Si$_2$H$_6$) in einem CVD-Prozeß erfolgen.

Ein weiterer, insbesondere bei Mehrlagenverdrahtung wichtiger, Vorteil des beschriebenen Metallisierungsverfahrens besteht darin, daß alle Abscheideschritte bei Temperaturen unterhalb von 450° C ablaufen können, also auch auf Halbleitersubstraten mit bereits einer Aluminiumlage.

Ein vereinfachtes Ausführungsbeispiel des erfindungsgemäßen Verfahrens ist die Beschränkung auf die Verfahrensstufen (a$_3$) und (a$_4$). Durch die Integration dieser beiden Verfahrensstufen in einer Hochvakuum-Anlage unter Aufrechterhaltung der Hochvakuum-Bedingungen für das Halbleitersubstrat werden bereits die wesentlichen mit der Erfindung verbundenen Vorteile erzielt.

2. Herstellung von Siliziden

In der Siliziumtechnologie werden Silizide eingesetzt, um temperaturstabile niederohmige Leitbahnen und Kontakte, insbesondere auch selbstjustierte Kontakte (sog. Salizide) zu erzeugen; dies ist beispielsweise in dem Buch von D. Widmann, H. Mader und H. Friedrich, Technologie hochintegrierter Schaltungen, Springerverlag 1988, S. 95 bis 98 näher erläutert. Die Herstellung von Siliziden und Saliziden ist mit dem erfindungsgemäßen Verfahren unter Einsatz der Verfahrensstufen (b$_1$) bis (b$_3$) auf einfache Weise möglich, ferner kann durch eine weitere Verfahrensstufe (b$_4$) sofort anschließend eine selektive Metallabscheidung, beispielsweise zur Auffüllung von Kontaktlöchern, vorgenommen werden:

(b$_1$) Vorbehandlung der Oberfläche
in der ersten Prozeßkammer 1 wird die zu beschichtende Oberfläche durch Beschuß mit beispielsweise niederenergetischen Argonionen (etwa 100 eV) gereinigt, dabei wird insbesondere im späteren Kontaktlochbereich und auf dem Polysilizium von Gatekontaktierungen das natürliche Oxid entfernt. Gleichzeitig mit dieser Reinigung der Oberfläche erfolgt ein Einbau von Argon-Atomen von etwa 10$^{13}$ Atome pro cm$^3$. Das Silizium wird voramorphisiert. Damit wird eine gleichmäßige Silizierung der Schichten unabhängig von der Dotierung erreicht.

b$_2$) Aufstäuben einer Metallschicht
In einer weiteren oder derselben Kammer der Hochvakuumanlage wird die für die Silizidbildung erforderliche Metallschicht durch Aufstäuben von einem Reinstmetalltarget ohne Vakuumunterbrechung auf der frisch gereinigten Oberfläche abgeschieden. Die Schichtdicke ist abhängig von den Geometrieverhältnissen des Kontaktlochs, dem Dotierungsprofil sowie der Vorbehandlung, und liegt typischerweise zwischen 40 und 80 nm.

(b$_3$) Temperaturbehandlung
Die Silizidbildung erfolgt mittels Rapid Thermal Processing oder Rapid Optical Annealing (RTP oder ROA), beispielsweise bei 650 bis 700° C in Stickstoff-Atmosphäre für 30 sec in einer Kammer der Hochvakuumanlage. Durch Aufrechterhaltung der Hochvakuumbedingung bildet sich auf den gemäß (b2) abgeschiedenen Metallschichten keine Oxidschicht.

(b4) Selektive Metallabscheidung
Wiederum ohne Unterbrechung des Hochvakuums kann nun auf den frisch silizierten Kontakten ohne Nukleationsverzögerung und mit ausgezeichneter Selektivität mittels eines CVD-Prozesses eine selektive Metallabscheidung von beispielsweise Wolfram oder Aluminium durchgeführt werden. Dazu wird eine weitere Kammer der Hochvakuumanlage und ein dem Stand der Technik entsprechender, selektiver Abscheideprozeß eingesetzt.

3. Selektive Metallabscheidung

Als weiteres Ausführungsbeispiel der Erfindung können die bereits beschriebenen Verfahrensstufen (a1) und (b4) kombiniert werden. Mit diesem mehrstufigen Verfahren wird eine selektive Metallabscheidung von beispielsweise Wolfram oder Aluminium auf frisch gereinigten Kontakten durchgeführt; es kann sich dabei um Kontakte zu unterliegendem Silizium oder zu unterliegenden metallischen Leitbahnen handeln. Durch eine vollständige Auffüllung der Kontakte wird die Planarisierung der Oberfläche erreicht.

Unabhängig vom jeweiligen Ausführungsbeispiel liegt der erfinderische Gedanke in der Kombination von mindestens zwei Verfahrensstufen unter Aufrechterhaltung der Hochvakuumbedingungen für das Halbleitersubstrat; zur Durchführung ist die erfindungsgemäße Mehrkammer-Hochvakuumanlage notwendig. Die einzelnen Verfahrensstufen können dabei nach dem Stand der Technik durchgeführt werden, dies gilt insbesondere für die in den Ausführungsbeispielen beschriebenen Verfahrensstufen (a1), (a2), (a5), (a6), (b1) - (b4). Dagegen ist die beschriebene Verfahrensstufe (a4) neu und die Verfahrensstufe (a3) sowie die Kombination aus (a3) und (a4) neu und erfinderisch.

**Patentansprüche**

1. Mehrstufiges Verfahren zur Herstellung von leitenden Schichten oder Strukturen für höchstintegrierte Schaltungen auf einem Halbleitersubstrat, bestehend aus mindestens zwei Verfahrensstufen, welche direkt hintereinander in mindestens zwei Kammern einer Hochvakuum-Anlage unter Aufrechterhaltung der Hochvakuum-Bedingungen für das Halbleitersubstrat ausgeführt werden.

2. Verfahren nach Anspruch 1,
**gekennzeichnet** durch die Verfahrensstufen
(a3) Aufbringen einer Barriereschicht auf die Oberfläche des Halbleitersubstrats
(a4) Aufbringen einer Leitbahnschicht auf die Barriereschicht.

3. Verfahren nach einem der Ansprüche 1 bis 2,
**gekennzeichnet** durch die weiteren Verfahrensstufen
(a2) Aufbringen einer Kontaktschicht vor Aufbringen der Barriereschicht und/oder
(a1) Reinigen der Oberfläche des Halbleitersubstrats vor Aufbringen der Barriereschicht oder der Kontaktschicht und/oder
(a5) Aufbringen einer Legierungsbestandteile liefernden Schicht vor, nach oder im Wechsel mit dem Aufbringen der Leitbahnschicht und/oder
(a6) Temperaturbehandlung.

4. Verfahren nach einem der Ansprüche 1 bis 3,
**dadurch gekennzeichnet,**
daß die Verfahrensstufen folgendermaßen ausgeführt werden:
(a1) Plasma-Ätzprozeß zur Entfernung von Oxiden
(a2) Aufbringen einer Titanschicht von 10 bis 100 nm Dicke durch einen Aufstäubprozeß, oder durch chemische Abscheidung aus der Gasphase (CVD-Prozeß) bei einer Temperatur im Bereich von 200 bis 450° C.
(a3) Aufbringen einer Titannitrid-Schicht durch einen CVD-Prozeß bei einer Temperatur von 200 bis 450° C unter Verwendung einer stickstoffhaltigen organischen Titanverbindung, welche thermisch und/oder optisch und/oder durch ein Plasma angeregt wird.
(a4) Aufbringen einer Aluminiumschicht oder einer Aluminiumlegierungs-Schicht durch einen CVD-Prozeß bei einer Temperatur von 200 bis 450° C unter Verwendung einer organischen Aluminiumverbindung, welche thermisch und/oder optisch und/oder durch ein Plasma angeregt wird.
(a5) Aufbringen einer metallischen Schicht, welche Kupfer, Titan, Palladium und/oder Silizium enthält, durch einen Aufstäubprozeß oder einen CVD-Prozeß in der für die gewünschte Legierung erforderlichen Dicke.
(a6) Kurzzeitiges Erhitzen des Halbleitersubstrats auf eine Temperatur bis zu 500° C für 10 bis 120 sec in einer Inertgas-Atmosphäre (RTP- oder ROA-Prozeß) zur Legierungsbildung.

5. Verfahren nach Anspruch 1,
**gekennzeichnet** durch die Verfahrensstufen
(b₁) Vorbehandlung der zu beschichtenden Oberfläche des Halbleitersubstrats
(b₂) Aufbringen einer metallischen Schicht
(b₃) Temperaturbehandlung.

6. Verfahren nach Anspruch 5,
**gekennzeichnet** durch die weitere Verfahrensstufe
(b₄) Selektive Metallabscheidung.

7. Verfahren nach einem der Ansprüche 1, 3, 4, 6,
**gekennzeichnet** durch die Kombination der Verfahrensstufen (a₁) und (b₄).

8. Verfahren nach einem der Ansprüche 5 bis 7,
**dadurch gekennzeichnet,** daß die Verfahrensstufen folgendermaßen ausgeführt werden.
(b₁) Beschuß mit Argon-Ionen zur Entfernung von Oxiden und zur Amorphisierung des Halbleitersubstrats
(b₂) Aufbringen einer Titan- oder Kobalt-Schicht durch Aufstäuben von einem Metalltarget
(b₃) Kurzzeitiges Erhitzen des Halbleitersubstrats auf bis zu $700°$ C in einer in Inertgas-Atmosphäre (RTP oder ROA) zur Bildung eines Silizids.
(b₄) Selektive Abscheidung von Wolfram oder Aluminium mittels eines CVD-Prozesses auf freiliegendem Silizium, Silizid oder Metall.

9. Vorrichtung zur Durchführung eines mehrstufigen Verfahrens zur Herstellung von Schichten oder Strukturen für höchstintegrierte Schaltungen auf einem Halbleitersubstrat, bestehend aus einer Mehrkammer-Hochvakuum-Anlage mit mindestens zwei Prozeßkammern (1 bis 6), mindestens zwei Vorratskammern (8, 9) und mindestens einer die Kammern miteinander verbindenden Verteilerkammer (7), wobei alle Kammern (1 - 9) und alle Verbindungen zwischen Kammern hochvakuumtauglich sind und die Kombination mehrerer, unterschiedlicher Verfahrensstufen ohne Unterbrechung der Hochvakuum-Bedingungen für das Halbleitersubstrat ermöglichen.

10. Vorrichtung nach Anspruch 9,
**gekennzeichnet** durch einen erreichbaren Basisdruck von weniger als $10^{-6}$ mbar in den Vorratskammern (8, 9) und weniger als $10^{-7}$ mbar in Verteiler- und Prozeßkammern (1-7).

**Europäisches Patentamt**

# EUROPÄISCHER RECHERCHENBERICHT

Nummer der Anmeldung

**EP 90 10 6139**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | ELECTRONICS. vol. 58, no. 37, September 1985, NEW YORK US Seite 21 "sputterer covers steep walls evenly" <br> * das ganze Dokument * <br> — — — | 1 | H 01 L 21/285 <br> H 01 L 21/90 |
| A | EP-A-0 284 794 (IBM) <br> * Zusammenfassung * <br> — — — | 2 | |
| A | IEEE TRANSACTIONS ON ELECTRON DEVICES. vol. ed34, no. 3, März 1987, NEW YORK US Seiten 700 - 705; k hinode et. al.: "silicon take-up by aluminium conductors layered with refractory metals" <br> * das ganze Dokument * <br> — — — | 3 | |
| A | EP-A-0 254 035 (HITACHI) <br> * Zusammenfassung * <br> — — — | 3 | |
| A | GB-A-2 181 297 (SGS MICROELECTRONICS) <br> * das ganze Dokument * <br> — — — | 4,5 | |
| A | JOURNAL OF THE ELECTROCHEMICAL SOCIETY. vol. 136, no. 3, März 1989, MANCHESTER, NEW HAMP Seiten 882 - 883; n yokoyama et.al.: "LPCVD TiN as barrier layer in VLSI" <br> * das ganze Dokument * <br> — — — | 4 | RECHERCHIERTE SACHGEBIETE (Int. Cl.5) <br><br> H 01 L |
| A | THIN SOLID FILMS. vol. 181, no. 1, 10 Dezember 1989, LAUSANNE CH Seiten 35 - 41; P. Panjan et. al.: "preparation and characterisation of multilayer metallisation structures with titanium nitride and titanium silicide" <br> * Seite 36, Zeile 5 - Seite 36, Zeile 28 * <br> — — — | 4 | |
| A | EP-A-0 064 805 (FUJITSU) <br> * Zusammenfassung * <br> — — — <br><br> —/— | 4 | |

Der vorliegende Recherchenbericht wurde für alle Patentansprüche erstellt

| Recherchenort | Abschlußdatum der Recherche | Prüfer |
|---|---|---|
| Den Haag | 03 Dezember 90 | PHEASANT N.J. |

Seite 2

**Europäisches Patentamt**

# EUROPÄISCHER RECHERCHENBERICHT

Nummer der Anmeldung

## EP 90 10 6139

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | APPLIED PHYSICS LETTERS. vol. 54, no. 17, 24 April 1989, NEW YORK US Seiten 1672 - 1674; R.V. Josho et. al.: "Novel self-aligned W/TiN/TiSi2 contact structure for very shallow junctions and interconnections" * das ganze Dokument * --- | 4,6-8 | |
| A | US-A-4 585 517 (MOTOROLA) * Zusammenfassung * --- | 8 | |
| X | EP-A-0 272 141 (APPLIED MATERIALS) * Zusammenfassung * --- | 9 | |
| X | US-A-4 825 808 (TAKAHASHI ET. AL.) * Zusammenfassung * ----- | 9 | |

RECHERCHIERTE SACHGEBIETE (Int. Cl.5)

Der vorliegende Recherchenbericht wurde für alle Patentansprüche erstellt

| Recherchenort | Abschlußdatum der Recherche | Prüfer |
|---|---|---|
| Den Haag | 03 Dezember 90 | PHEASANT N.J. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument
\-\-\-\-\-\-\-\-\-\-\-\-\-\-\-\-\-\-\-\-\-\-\-\-\-\-\-\-\-\-\-\-\-\-\-\-\-\-
& : Mitglied der gleichen Patentfamilie, übereinstimmendes Dokument